# FASCICULE DE BREVET EUROPEEN

(11) **EP 1 380 104 B1**
(45) Date de publication et mention de la délivrance du brevet: **08.10.2008**
(21) Numéro de dépôt: 02722394.0
(22) Date de dépôt: 05.04.2002
(51) Int. Cl.: H03H 7/06

(54) **FILTRE PASSE-BAS A COMPOSANTS UNIQUEMENT PASSIFS DESTINE AU DECOUPLAGE DES VOIES XDSL**
TIEFPASSFILTER MIT AUSSCHLIESSLICH PASSIVEN ELEMENTEN ZUR ENTKOPPLUNG DER XDSL-ÜBERTRANGUNGSKANÄLE
LOW-PASS FILTER WITH ONLY PASSIVE COMPONENTS FOR XDSL PATH DECOUPLING

(30) Priorité: 17.04.2001 FR 0105213
(43) Date de publication de la demande: 14.01.2004
(73) Titulaire: Laboratoire Europeen ADSL, 92400 Courbevoie (FR)
(72) Inventeur: LECORDIER, Céline, F-35000 Rennes (FR); BERTHAUD, Eric, F-37380 Reugny (FR); DEDIEU, Hervé, F-35500 Vitre (FR)
(74) Mandataire: Schmit, Christian Norbert Marie
(86) Numéro de dépôt international: PCT/FR2002/001206
(87) Numéro de publication internationale: WO 2002/084867

(56) Documents cités:
- WO-A-00/65819
- WO-A-01/06737
- WO-A-99/45643
- COOK J ET AL: "ADSL AND VADSL SPLITTER DESIGN AND TELEPHONY PERFORMANCE" IEEE JOURNAL ON SELECTED AREAS IN COMMUNICATIONS, IEEE INC. NEW YORK, US, vol. 13, no. 9, décembre 1995 (1995-12), pages 1634-1642, XP002938841 ISSN: 0733-8716
- DIETER NÜHRMANN: "Das grosse Werkbuch Elektronik" 31 décembre 1994 (1994-12-31), FRANZIS-VERLAG GMBH , POING ISBN: 3-7723-6546-9 chapitre 2.2 * page 582 - page 583 *

## Description

La présente invention se rapporte à la, technique dite xDSL, typiquement ADSL Asynchronous Digital Subscriber Line - Ligne d'abonné numérique asynchrone. Pour des transmissions selon cette technique, on convient d'utiliser une paire de fils de cuivre, notamment torsadée, pour transmettre à la fois, en bande de base, des signaux analogiques non modulés ou numériques modulés en bande de base, et en bande haute d'autres signaux modulés. Les signaux analogiques en bande de base sont de fréquence typiquement 0 à 4000 Hz, jusqu'à 16 KHz avec la signalisation. Ils sont véhiculés dans des réseaux analogiques dit POTS (Plain Old Transmission System - système ancien de télécommunications). Les signaux numériques en bande de base sont transportés dans des réseaux dits ISDN (où RNIS - réseau numérique à intégration de services). Ils y sont modulés en bande de base dans des fréquences de 0 à 94 KHz. La bande haute s'étale du dessus de la bande de base jusqu'à 1 MHz environ. En pratique la bande haute s'étale de 32 KHz à 1,1 MHz si la paire de fils de cuivre sert en bande de base pour une transmission analogique, et de 138 KHz à 1,1 MHz si elle sert pour une transmission numérique.

La bande haute est utilisée pour la transmission numérique. Elle est normalement destinée à une transmission permanente, en mode de paquets principalement, alors que la bande de base est destinée en pratique à une transmission en mode de circuit. Pour simplifier les explications, on pourra admettre que typiquement la bande de base sert pour la transmission de paroles et que typiquement la bande haute sert pour la transmission de données, notamment la consultation de sites Internet. Toutefois, la bande de basse sert aussi, notamment avec des modems (et en particulier avec des modems numériques), à transmettre des données, alors que la bande haute peut servir à assurer des communications phoniques. On parle à ce sujet de communications téléphoniques sur Internet. Il reste dans tous les cas que la bande de base n'est capable que d'un faible débit (actuellement 56 Kbits/s pour les modems analogiques et 64 Kbits/s pour les modems numériques) comparé à un haut débit (typiquement 10 Mbits/s) pour la bande haute.

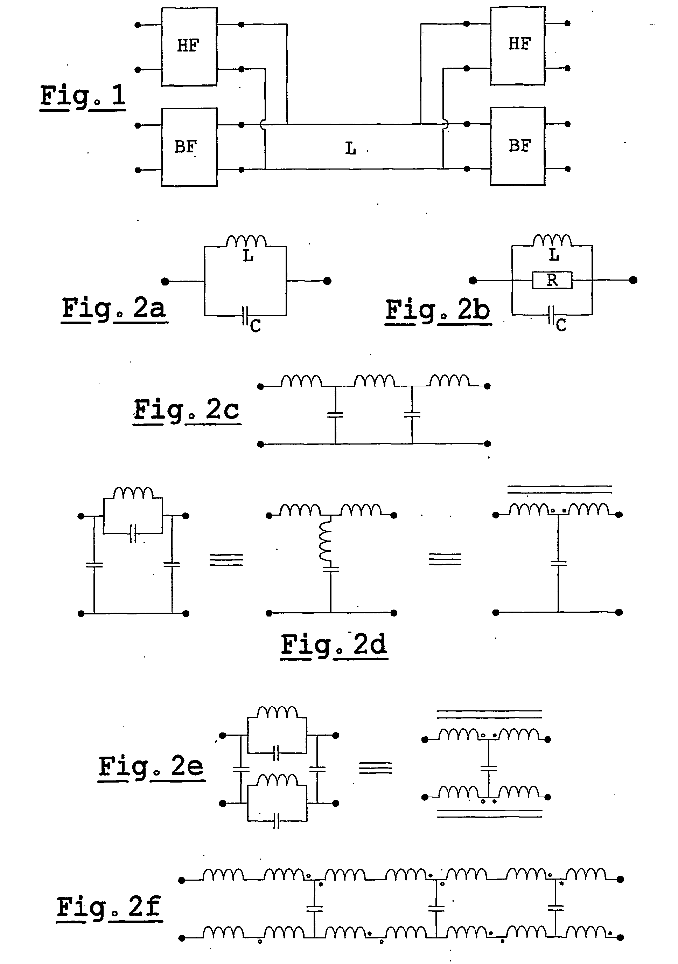

L'utilisation d'une ligne dite ADSL nécessite donc, voir figure 1, de séparer la bande de base, basse fréquence - BF, de la bande haute, dite haute fréquence - HF. Une installation ADSL comporte alors dans ce but, deux paires de filtres montés en parallèle sur les deux brins de la paire L de fils de cuivre, côté opérateur de téléphonie et côté abonné. Un premier filtre d'une paire est un filtre BF le second est un filtre HF. Le premier filtre est raccordé en amont à un multiplexeur-répartiteur de téléphonie classique, le second est raccordé à un multiplexeur-répartiteur de transmission numérique haut débit. Côté abonné, le premier filtre est raccordé au téléphone, le second est raccordé à un modem ADSL. Chaque filtre sert à isoler l'installation qu'il relie des signaux destinés à l'autre installation. Notamment, le filtre BF côté abonné sert à empêcher qu'un auditeur n'entende un chuintement permanent.

Avant l'apparition de la technique xDSL, les lignes devraient être bouclées de part et d'autre par une impédance caractéristique, en théorie la même des deux côtés, pour assurer que la puissance transmise par la ligne le soit avec le meilleur rendement possible. On appelle Zc une telle impédance caractéristique. Dans la pratique Zc est une valeur imposée par une norme. Le problème se complique un peu du fait que coexistent cinq normes : la norme européenne harmonisée, la norme anglaise, la norme allemande, et deux normes américaines dites à 600 ohms et 900 ohms respectivement. Les différences entre ces normes dépendent du diamètre des fils de cuivre utilisés, de l'isolant et du pas des torsades. Le point commun de ces normes est que seule était prise en compte la composante purement résistive de l'impédance caractéristique. Par ailleurs les impédances concernées ont des valeurs sensiblement comparables.

Avec l'apparition de la technologie xDSL, d'une part la présence des filtres HF est rendue nécessaire pour séparer les voies en fréquence, et d'autre part la prise en compte de l'impédance avec sa composante réactive devient prépondérante. La figure 1 montre la structure nécessaire avec de part et d'autre de la ligne L, deux filtres passe bas, BF à relier aux voies basses fréquences, et deux filtres passe haut en parallèle, HF, à relier aux modems xDSL. Apparaissent alors d'une manière critique deux autres contraintes supplémentaires imposées par les normes. Ces deux contraintes sont le facteur de pertes par insertion dit Insertion Loss - ILF, et le facteur de pertes par réflexion dit Return Loss - RLF. Le facteur de perte ILF mesure la perte de transmission occasionnée dans le circuit par la mise en place d'un filtre, entre une situation où le filtre n'est pas présent et une situation où il est mis en place. Cette perte doit rester inférieure à 1 dB à 1 KHz si Zc est complexe, alors qu'elle devait rester inférieure à 0,3 dB si Zc était réel. Le facteur RLF, égal à 10log₁₀(Zin-Zc)/(Zin+Zc), impose un gabarit selon lequel, approximativement, l'atténuation en réflexion pour le filtre 8F doit être supérieure environ à 18 dB dans la bande de base utile (300 - 3400 Hz en réseau POTS, et 300 - 94000 Hz en réseau ISDN).

Pour tenter de satisfaire à toutes ces contraintes, il a été imaginé différents types de filtres.

Il est par exemple connu les enseignements des documents WO 99 45643 A (BEICHLER JOHANNES ; VACUUMSCHMELZE GMBH [DE] ; PETZOLD JOERG [DE] ; H), WO 01 06737 A (2WIRE INC), COOK J ET AL: ADSL AND VADSL SPLITTER DESIGN AND TELEPHONY PERFORMANCE' IEEE JOURNAL ON SELECTED AREAS IN COMMUNICATIONS, IEEE INC. NEW YORK, US, vol.13, no.9, décembre 1995, pages 1634-1642, XP002938841 ISSN: 0733-8716 et extrait de NÜHRMANN, DIETER : 'Das große Werkbuch Electronik, Band 1', 1994, FRANZIS-VERLAG, POING, ISBN 3-7723-6546-9, chapitre2.2, p.582, 583

Notamment dans la demande de brevet FR-A-2 793 633, qui par ailleurs présente un contexte de l'invention, il est prévu des filtres avec des éléments actifs, en particulier des diodes, notamment des diodes Zener pour séparer la voie BF de la voie HF. Alors que le filtre HF sera naturellement directement incorporé dans un modem xDSL, à brancher en parallèle sur une paire de fils de cuivre existante (et par là même procurera le filtre HF de séparation), il importe pour un opérateur de faire placer au moment de cette installation, aux extrémités de la ligne, côté abonné et côté opérateur, des filtres passe bas. Vu le nombre important d'abonnés, le nombre de filtres passe bas à fournir est ainsi important. Leur coût doit être minimisé. La réalisation décrite dans le document cité ci-dessus est de ce point de vue trop onéreuse.

Le présent demandeur a également réalisé un filtre passe bas dans ce but. Cependant pour satisfaire toutes les contraintes de toutes les normes en même temps, il a été amené à proposer un premier filtre passe bas avec des éléments dissipatifs ce qui se heurte, en théorie, aux exigences liées au facteur ILF. Un tel premier filtre comporte alors pour résoudre ce problème une impédance résistive négative. Une telle résistance négative ne peut être réalisée que sur la base d'un filtre actif, avec des amplificateurs opérationnels. Une telle réalisation nécessite donc une alimentation électrique, ce qui n'est pas envisageable car interdit pour les installations de téléphone classique (celles pour lesquelles le téléphone installé ne comporte pas sa propre alimentation électrique).

Dans l'invention, on a alors découvert qu'il existait une possibilité de réaliser un filtre passe bas, destiné au découplage des voies xDSL dans une transmission de type ligne bifilaire entièrement passif (sans composant actif chers et consommateurs de courant électrique) et qui permettait alors de satisfaire en même temps toutes les contraintes imposées par toutes les normes citées. Ce filtre est particulièrement complexe en ce sens qu'il comporte plus de quinze éléments réactifs et que sa mise au point à été particulièrement délicate.

Parmi les structures de filtre connues, on distingue, figures 2a et 2b, les dipôles LC en parallèle, éventuellement en parallèle avec une résistance. Pour réaliser un filtre passe bas, on peut alors adopter, figure 2c, des quadripôles à insérer dans une ligne avec des cellules de filtres dont les pôles sont à l'infini. Par exemple, ici la cellule passe bas est en Pi avec des inductances dans une branche de transmission et des condensateurs en parallèle entre les branches. Dans l'invention, on a découvert que ce type de filtre ne convenait pas.

Par contre on a découvert que des filtres avec des cellules de filtre de Cauer, dites cellules elliptiques, figure 2d, pour lesquelles certains pôles ne sont pas à l'infini, pouvaient permettre de souscrire aux exigences des normes. Un filtre elliptique est ainsi en raccourci un filtre dans lequel une inductance de branche est remplacée par un dipôle LC. La partie au centre et la partie à droite de la figure 2d sont des équivalents duaux de la cellule elliptique montrée à gauche. Dans la partie de droite, la cellule duale est réalisée, selon l'invention avec une économie de condensateurs (il n'y en a plus que un, monté en parallèle entre deux branches, en étant relié au point milieu de deux inductances en série et qui sont par ailleurs couplées l'une à l'autre).

Sur la figure 2e, le filtre de la figure 2d est rendu symétrique, les composants dans une branche de transmission, la branche supérieure ici, étant de même valeur et identiques aux composant dans l'autre branche, la branche inférieure. L'allure de droite de la figure 2e montre une cellule, préférée, symétrique et duale d'une cellule elliptique théorique. Cette structure duale elliptique et symétrique forme une structure de base des filtres de l'invention. Ces filtres des figures 2d et 2e présentent l'avantage d'avoir une bande de transition raide, dans laquelle l'atténuation croît fortement entre un dernier zéro et un premier pôle du filtre. Un tel filtre elliptique permet donc de disposer d'une forte réjection des signaux xDSL.

Toutefois, avec les trois exigences d'impédance complexe mentionnées ci-dessus, du fait de l'existence des trois normes, on pourrait montrer qu'aucun filtre à base de cellule elliptique duale et symétrique pure ne peut être solution. Dans l'invention, on a alors eu l'idée de munir un tel quadripôle résonnant (comme ceux des figures 2d et 2e) d'un dipôle dissipatif, un correcteur, par exemple du type de celui décrit dans la précédente demande du même demandeur. Un tel correcteur comporte en pratique une inductance en parallèle avec une résistance. Normalement, le fait de mettre des éléments dissipatifs est prohibé, compte tenu de l'exigence particulièrement sévère du facteur ILF qui interdit une quelconque atténuation. Dans l'invention, on va quand même en mettre un, mais en même temps on va tirer parti des pôles non à l'infini (et des suroscillations que ces pôles rapprochés produisent) pour respecter les normes. En effet on a pu mesurer que la présence d'un élément résonnant de type LC en parallèle, mis en série, de concert avec la présence en série dans une branche d'un élément dissipatif de type RC en parallèle, peut alors permettre une bonne maîtrise des impédances d'entrée du filtre passe bas, vu tant du côté ligne que du côté utilisation (abonné ou opérateur). Avec une telle réalisation, on peut montrer qu'on satisfait en même temps à toutes les contraintes.

L'invention a donc pour objet un filtre passe bas à composants uniquement passifs, à utiliser en raccordement d'une voie basse fréquence à une ligne bifilaire, cette ligne bifilaire délivrant des signaux dans cette voie basse fréquence et des signaux dans une voie haute fréquence, caractérisé en ce qu'il comporte au moins une cellule de type elliptique ou dual elliptique et un dipôle dissipatif interposé à titre de structure corrective dans la transmission.

Sur le plan pratique, les cellules utilisées seront de préférence des cellules symétriques, avec dans les deux branches des éléments résonnant LC ou des inductances, du fait de l'économie de condensateurs. Dans les deux branches de transmission du quadripôle sont alors présentes des inductances, en principe de valeurs égales dans chaque branche. De préférence alors, par rapport à une telle solution avec cellule elliptique, on choisira des cellules avec structure duale elliptique. Elles sont montrées sur la figure 2f. Le caractère dual elliptique est en fait porté par les valeurs des différents composants inductances et condensateurs. Selon un aspect l'invention, représenté schématiquement par les figures 2d et 2e, on peut ajouter dans une ou l'autre des branches de transmission de ces cellules, voire dans les deux, des dipôles dissipatifs. On montrera par la suite que le problème soulevé en est résolu.

Par rapport à une solution montrée figure 2c (et qui ne convient pas même si on y adjoint un dipôle dissipatif en série), la solution de la figure 2e peut présenter l'inconvénient de devoir réaliser beaucoup d'inductances, deux par branche de cellule. Dans l'invention, on a alors eu l'idée, pour réduire les coûts de bobiner les deux inductances d'une branche, situées de part et d'autre d'un noeud intermédiaire d'une cellule autour d'un même noyau magnétique. On gagne alors très nettement en prix. De préférence alors, avec une solution symétrique, les quatre inductances d'une cellule (celles qui sont reliées à des bornes d'un même condensateur de la cellule) sont bobinées sur un seul et même noyau. On gagne encore plus en coût.

Dans ces condition, l'invention a pour objet un filtre passe bas à composants uniquement passifs, à utiliser en raccordement d'une voie basse fréquence à une ligne bifilaire, cette ligne bifilaire délivrant des signaux dans cette voie basse fréquence et des signaux dans une voie haute fréquence, caractérisé en ce qu'il comporte au moins une cellule de type dual elliptique et symétrique avec quatre bobines reliées aux bornes d'un même condensateur, les quatre bobines étant bobinées sur un même noyau.

Enfin, comme on le verra plus loin, du fait de d'une évolution des normes vers leur harmonisation, il est envisageable de proposer un filtre passe bas, sans éléments dissipatifs. Dans ce but l'invention a également pour objet un filtre passe bas avec une structure et des valeurs de composants précisément déterminées. Cette solution est unique.

L'invention sera mieux comprise à la lecture de la description qui suit et à l'examen des figures qui l'accompagnent. Celles-ci ne sont présentées qu'à titre indicatif et nullement limitatif de l'invention. Les figures montrent :
- figure 1 : déjà commentée, l'allure générale de filtres à placer sur une ligne L servant à transmettre une voie en bande de base et une voie xDSL;
- figures 2a à 2f : déjà commentées, des structures de filtre connues en soi mais utilisables dans l'invention ;
- figures 3a à 3e : une représentation schématique de variantes de réalisation d'un filtre passe bas selon l'invention ;
- figures 4a et 4b : l'intégration de la variante de la figure 3d dans un filtre avec commutation et comportant en bande de base une voie analogique et une voie numérique ;
- figure 5 : un filtre passe bas utilisable indifféremment en bande de base dans une voie analogique ou dans une voie numérique.

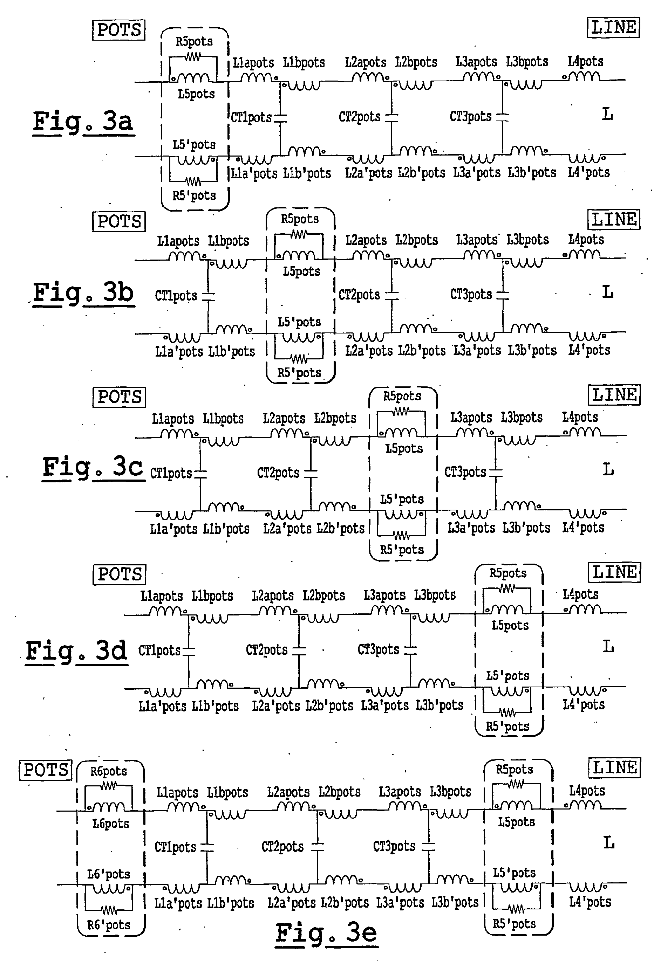

Les figures 3a à 3e montrent des variantes préférées de réalisation du filtre passe bas de l'invention. Le quadripôle général représenté comporte un côté dit POTS, à raccorder à un terminal de l'abonné, ou au multiplexeur répartiteur de l'opérateur, et un côté LINE à raccorder du côté de la ligne L (figure 1). Dans ces figures, trois cellules de filtrage duales elliptiques et symétriques (conformes à la figure 2e à droite) sont à chaque fois montées en cascade. Un élément dissipatif, lui aussi réalisé sous une forme symétrique est inséré en divers endroits de cette cascade. Il est situé avant la première cellule sur la figure 3a, entre la première et la deuxième cellule figure 3b, entre la deuxième et la troisième cellule figure 3c, et après la troisième et dernière cellule, côté LINE, figure 3d. Le filtre comporte par ailleurs deux inductances symétrique de liaison côté LINE, après la troisième cellule.

L'élément dissipatif comporte de préférence deux sous éléments montés symétriquement en série dans une branche. Chaque sous élément comporte un dipôle RL avec une résistance R5 en parallèle d'une inductance L5, et les mêmes élément élidés pour l'autre branche.

La figure 3e montre une variante de ces figures 3a à 3d dans laquelle l'élément dissipatif est réparti en deux paires de sous éléments, ici une paire étant placée comme sur la figure 3a, l'autre paire étant placé comme sur la figure 3d. On aurait bien entendu pu également prévoir soit de placer une des paires selon l'une quelconque des configurations des figures 3a à 3d et l'autre paire selon une autre quelconque des configurations 3a à 3d. On aurait également pu répartir l'élément_dissipatif sur plus de deux paires.

Chaque cellule comporte dans une branche de transmission un couple d'inductances en série et couplées mutuellement, par exemple L1aₚₒₜₛ et L1b pots, et dans une autre branche un autre couple d'inductances en série et également couplées mutuellement, par exemple L1a'ₚₒₜₛ et L1b'ₚₒₜₛ. Par ailleurs entre les noeuds intermédiaires des inductances en série un condensateur CT1ₚₒₜₛ est connecté. L'indice pots signifie que le filtre est destiné à servir pour relier une ligne bifilaire utilisable en analogique. On verra plus loin qu'une solution du même type est envisageable pour une ligne numérique en bande de base, de type ISDN, pour laquelle les contraintes sont différentes. Pour cette solution du même type, les indices seront isdn.

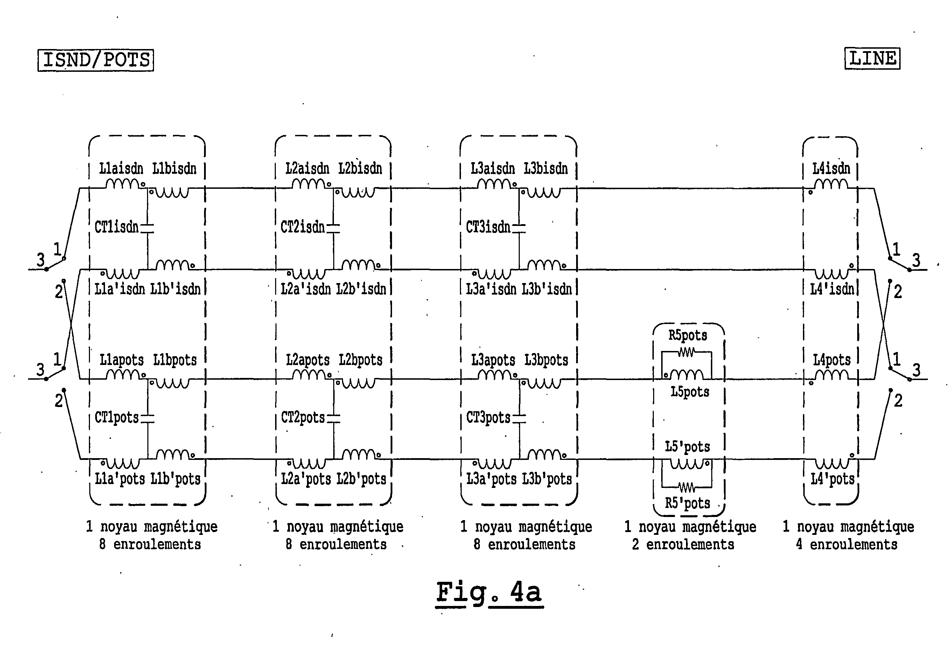

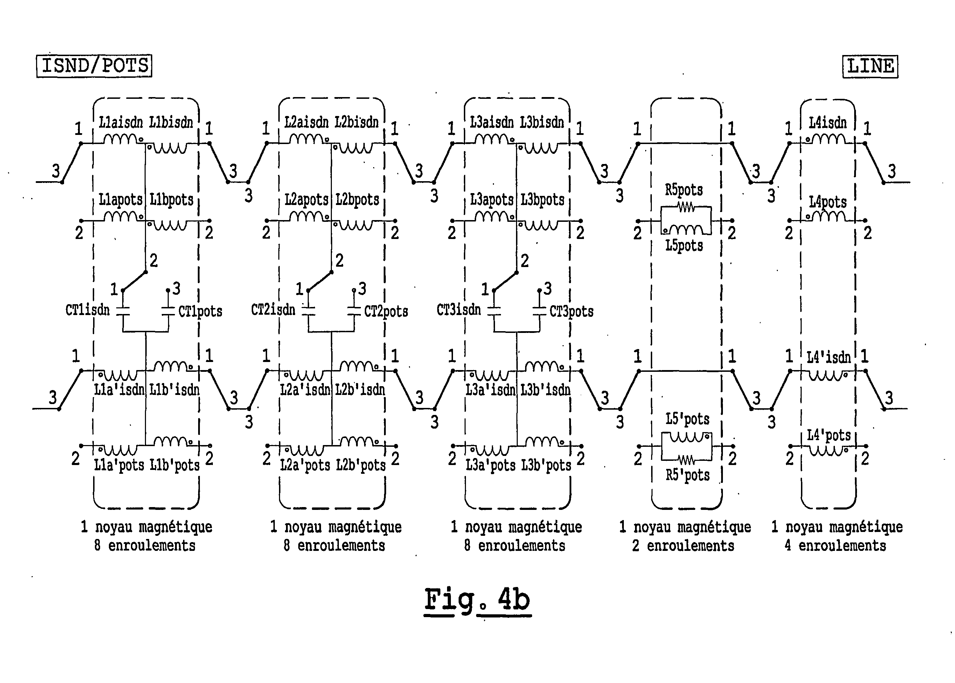

Les figures 4a et 4b montrent en particulier une variante de ce type, dans laquelle le filtre comporte deux voies filtrées. Une première voie concerne ainsi une utilisation sur transmission de type ISDN, et les composants du filtre sont indicés isdn. Une autre voie concerne une utilisation pour transmission analogique, elle est indicée pots. Pour cette autre voie, le filtre représenté est celui préféré de la figure 3d parce qu'il donne par ailleurs les meilleurs résultats. Dans la pratique, une ligne d'abonné qui aboutit chez un abonné est d'un type ou d'un autre, POTS ou ISDN, pas les deux. En effet, les caractéristiques de la ligne changent d'un cas à l'autre, notamment parce que la ligne bifilaire ISDN est censée laisser passer des signaux jusqu'à 94 KHz. L'opérateur équipe ainsi l'utilisateur avec une ligne ou une autre selon le besoin (et le coût).

Cependant, pour des installateurs de modems xDSL, il y a intérêt à ne disposer que d'un seul type de bloc de filtrage. Dans ce but, le bloc proposé par l'invention comporte, en entrée et en sortie des deux voies et également au milieu des voies, des commutateurs permettant de mettre en service exclusivement l'une ou l'autre de ces voies. Pour éviter alors d'avoir à supporter les frais de deux filtres (ce qui en théorie devrait doubler le coût du bloc), on prévoit de réaliser les deux filtres de la même façon, notamment avec des cellules elliptiques duales et symétriques. Dans ce cas, on utilise le perfectionnement consistant à bobiner quatre bobines d'une même cellule sur un même noyau pour bobiner sur le même noyau, les quatre autres bobines de la cellule homologue dans l'autre voie. En agissant ainsi on gagne trois noyaux. Il y a huit enroulements sur un noyau dans chaque cellule. Il n'y a pas d'inconvénient car les bobines non reliées par les commutateurs restent en l'air et n'interviennent pas pour modifier le filtrage de l'autre voie.

La figure 4a est une figure de principe, dans laquelle les deux voies filtrées sont séparées au moyen de quatre commutateurs. Sur la figure 4a toutefois, lorsqu'un voie est inemployée, les bobines en l'air de ses branches de transmission peuvent, par induction mutuelle, déséquilibrer le filtre formé par les bobines connectées. On préfère alors, selon la figure 4b, placer quatre commutateurs à chaque fois entre chaque cellule du filtre. Dans ces condition, chaque bobine inemployée est mieux découplée des autres. Deux commutateurs de ces quatre commutateurs servent pour raccorder les deux branches de transmission d'une cellule d'une voie filtrée (ou de l'autre voie filtrée) à deux noeuds de liaison. Les deux autres commutateurs de ces quatre commutateurs servent à relier les deux noeuds de liaison aux deux branches de transmission de la cellule en cascade de la même voie filtrée (ou de l'autre voie filtrée respectivement). Un commutateur supplémentaire par cellule permet de relier un point milieu commun à un premier couple de deux inductances en série à une première borne d'un condensateur ou à une première borne d'un autre condensateur, pour servir pour une voie filtrée ou l'autre respectivement. Les deuxièmes bornes des deux condensateurs sont reliées ensemble et à un point milieu commun à un deuxième couple de deux inductances en série. Pour trois cellules, deux correcteurs symétriques et deux inductances de liaison on obtient ainsi un montage à 23 commutateurs à chacun deux positions seulement. Ces commutateurs peuvent être mécaniques.

On donne en fin de description, dans le tableau TABLEAU 1, les valeurs des inductances résistances et condensateurs correspondant à la variante de la figure 4. Celle-ci correspond pour la voie analogique, indicées pots, à la solution de la figure 3d. Dans celle-ci, l'élément dissipatif est de préférence réalisé par une paire de résistance et d'inductances. Les inductances sont de préférence bobinées sur un même noyau, de sorte que toute la structure ne comporte que cinq noyaux, en comptant le noyau des inductances de liaison.

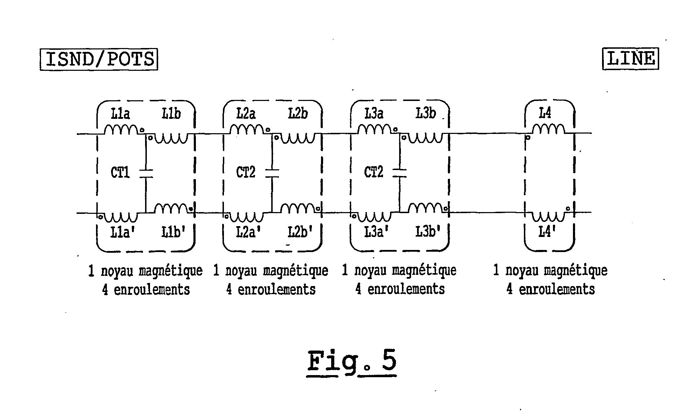

En suivant ce concept inventif selon lequel on était passé à des cellules duales elliptiques et symétriques, munies de correcteur dissipatif, puis à des bobinages tous reliés sur un même noyau, on a par ailleurs voulu tenir compte d'une évolution vers une moins grande exigence d'une norme la plus exigeante. Dans l'invention on s'est alors rendu compte qu'avec des cellules elliptiques duales et symétriques, on pouvait satisfaire à toutes les requêtes, sans mettre même de correcteur, d'élément dissipatif résistif. La structure trouvée est celle de la figure 5, avec trois cellules et, côté ligne, une inductance L4 ou L4' de liaison sur chacune des branches de transmission. Les valeurs qui vont bien sont celles du tableau TABLEAU 2 ci-après. On pourrait montrer que cette solution est la seule qui, convienne, les contraintes ne ménageant que peu d'espace au valeur des composants pour qu'une même valeur satisfasse à toutes les exigences.

En ce qui concerne les calculs des valeurs des filtres, on notera qu'ils résultent d'une démarche d'optimisation complexe. En effet, les filtres des figures 3a à 3e et 5 comportent 21 éléments. Ceux de la version ISDN, figures 4 et 5 en comportent 17. Les tolérances de réglage des composants aux valeurs trouvées sont autour de plus ou moins 5 à 10%. Pour la solution de la figure 3a à 3e, l'invention apporte l'enseignement que de telles solutions sont possibles, alors qu'auparavant rien ne permettait de le penser.

**TABLEAU 1**

| | |
|---|---|
| L1a_{isdn}, L1a'_{isdn} | 52.9^{µ}H |
| L1b_{isdn}, L1b'_{isdn} | 1-6^{µ}H |
| L1aₚₒₜₛ, L1a'ₚₒₜₛ | 250.0^{µ}H |
| L1bₚₒₜₛ, L1b'ₚₒₜₛ | 10.0^{µ}H |
| CT1_{isdn} | 13.6nF |
| CT1ₚₒₜₛ | 6.8nF |
| L2a_{isdn}, L2a'_{isdn} | 122.5^{µ}H |
| L2b_{isdn}; L2b'_{isdn} | 3.6^{µ}H |
| L2aₚₒₜₛ, L2a'ₚₒₜₛ | 211.6^{µ}H |
| L2bₚₒₜₛ, L2b'ₚₒₜₛ | 6.4^{µ}H |
| CT2_{isdn} | 13.6nF |
| CT2ₚₒₜₛ | 6.8nF |
| L3a_{isdn}, L3a'_{isdn} | 122.5^{µ}H |
| L3b_{isdn}, L3b'_{isdn} | 1.6^{µ}H |
| L3aₚₒₜₛ, L3a'ₚₒₜₛ | 230.4^{µ}H |
| L3bₚₒₜₛ, L3b'ₚₒₜₛ | 2.5^{µ}H |
| CT3_{isdn} | 15nF |
| CT3ₚₒₜₛ | 3.9nF |
| R5, R5' | 68^{Ω} |
| L5, L5' | 5.3235mH |
| L4_{isdn}, L4'_{isdn} | 96.1^{µ}H |
| L4ₚₒₜₛ, L4'ₚₒₜₛ | 336.4^{µ}H |

**TABLEAU 2**

| | |
|---|---|
| L1a, Lia' | 44,1µH |
| CT1 | 12nF |
| L1b, L1b' | 1,6µH |
| L2a, L2a' | 108,9µH |
| CT2 | 13,5nF |
| L2b, L2b' | 3,6µH |
| L3a, L3a' | 122,5µH |
| CT3 | 15,39nF |
| L3b, L3b' | 2,5µH |
| L4, L4' | 102,4µH |

## Revendications

1. Filtre passe bas à composants uniquement passifs, à utiliser en raccordement d'une voie basse fréquence à une ligne bifilaire, cette ligne bifilaire délivrant des signaux dans cette voie basse fréquence et des signaux dans une voie haute fréquence, **caractérisé en ce qu'**il comporte au moins une cellule de type elliptique (fig.2d) ou dual elliptique (fig.2e) et un dipôle dissipatif, comportant une inductance (L5pots ; L5'pots) en parallèle sur une résistance (R5pots ; R5'pots), interposé entre la ligne bifilaire de transmission et la cellule de type elliptique ou dual elliptique, ou interposé entre un terminal d'abonné raccordé au filtre et la cellule de type elliptique ou dual elliptique.

2. Filtre selon la revendication 1, **caractérisé en ce qu'**il comporte au moins trois cellules quadripôles elliptiques interposées sur deux branches de transmission, le dipôle dissipatif étant interposé sur au moins une branche entre une première et une deuxième cellule.

3. Filtre selon la revendication 2, **caractérisé en ce qu'**une cellule comporte deux branches de transmission, une au moins de ces branches comportant une inductance (L1apots ; L1bpots ; L1a'pots ; L1b'pots) en série, et un condensateur (CT1pots) en parallèle entre les deux branches.

4. Filtre selon l'une des revendications 2 à 3, **caractérisé en ce que** qu'une cellule comporte deux branches de transmission, une au moins de ces branches comportant une inductance, cette inductance étant en série avec une inductance d'une cellule contiguë, un condensateur étant relié en parallèle entre un point intermédiaire entre les deux inductances et l'autre branche.

5. Filtre selon la revendication 4, **caractérisé en ce que** les deux inductances en série sont bobinées sur un même noyau.

6. Filtre selon l'une des revendications 1 à 5, **caractérisé en ce qu'**il est de type symétrique.

7. Filtre selon la revendication 5 et la revendication 6, **caractérisé en ce que** deux inductances en série dans une branche de transmission sont bobinées sur un même noyau que deux inductances en série de l'autre branche de transmission.

8. Filtre selon l'une des revendications 1 à 7, **caractérisé en ce que** le dipôle dissipatif comporte une inductance en parallèle sur une résistance et en parallèle sur un condensateur.

9. Filtre passe bas à composants uniquement passifs, à utiliser en raccordement d'une voie basse fréquence à une ligne bifilaire, cette ligne bifilaire délivrant des signaux dans cette voie basse fréquence et des signaux dans une voie haute fréquence, ledit filtre comportant un dipôle dissipatif interposé dans une branche de transmission, et au moins une cellule de type dual elliptique (fig.2e) et symétrique avec quatre bobines reliées aux bornes d'un même condensateur, les quatre bobines étant bobinées sur un même noyau, **caractérisé en ce que** le dipôle dissipatif comporte une inductance (L5pots ; L5'pots) en parallèle sur une résistance (R5pots ; R5'pots).

10. Filtre selon la revendication 9, **caractérisé en ce que** le dipôle dissipatif comporte une inductance en parallèle sur une résistance et en parallèle sur un condensateur.

11. Filtre selon des revendications 9 à 10, **caractérisé en ce qu'**il comporte au moins trois cellules quadripôles elliptiques interposées sur deux branches de transmission, le dipôle dissipatif étant interposé sur au moins une branche entre une première et une deuxième cellule.

12. Filtre selon l'une des revendications 9 à 11, **caractérisé en ce qu'**il comporte deux voies de transmission basse fréquence reliées à la ligne bifilaire par un commutateur, les deux voies étant filtrées avec des filtres à cellules de type dual elliptique et symétrique, avec quatre bobines reliées aux bornes d'un même condensateur, quatre bobines d'une cellule du filtre d'une voie étant bobinées sur un même noyau, quatre autres bobines d'une cellule du filtre de l'autre voie étant bobinées sur le même noyau.

13. Filtre selon l'une des revendications 9 à 12, **caractérisé en ce qu'**il comporte trois cellules de type dual elliptique et symétriques montées en cascade avec deux inductances de liaison arrangé dans le circuit de la figure 5, les composants respectifs possédant les valeurs du tableau suivant, à plus ou moins 10% :
| | |
|---|---|
| L1a, Lia' | 44,1µH |
| CT1 | 12nF |
| L1b, L1b' | 1,6µH |
| L2a, L2a' | 108,9µH |
| CT2 | 13,5nF |
| L2b, L2b' | 3,6µH |
| L3a, L3a' | 122,5µH |
| CT3 | 15,39nF |
| L3b, L3b' | 2,5µH |
| L4, L4' | 102,4µH |

## Claims

1. A low-pass filter solely with passive components, to be used for linking up a low frequency route to a bifilar line, such bifilar line producing signals in such low frequency route and signals in a high frequency route, **characterized in that** it comprises at least one elliptic (fig.2d) or dual elliptic (fig.2e) type cell and a dispersing 2-terminal circuit, comprising an inductance (L5pots ; L5'pots) in parallel on a resistance (R5pots ; R5'pots), interposed between the bifilar transmission line and the elliptic or dual elliptic type cell, or interposed between a subscriber's terminal linked to the filter and the elliptic or dual elliptic type cell.

2. A filter according to claim 1, **characterized in that** it comprises at least three elliptic 4-terminal circuit cells interposed on two transmission branches, the dispersing 2-terminal circuit being interposed on at least one branch between a first and a second cell.

3. A filter according to claim 2, **characterized in that** one cell comprises two transmission branches, at least one of these branches comprising an inductance (L1apots ; L1bpots ; L1a'pots ; L1b'pots) in tandem, and a condenser (CT1 pots) in parallel between the two branches.

4. A filter according to one of the claims 2 to 3, **characterized in that** one cell comprises two transmission branches, at least one of these branches comprising an inductance, such inductance being in tandem with an inductance of a closely related cell, a condenser being linked in parallel between an intermediary point in between the two inductances and the other branch.

5. A filter according to claim 4, **characterized in that** the two inductances in tandem are reeled onto a same core.

6. A filter according to one of the claims 1 to 5, **characterized in that** it is of the symmetrical type.

7. A filter according to claim 5 and to claim 6, **characterized in that** the two inductances in tandem in a transmission branch are reeled onto a same core as the two inductances in tandem on the other transmission branch.

8. A filter according to one of the claims 1 to 7, **characterized in that** the dispersing 2-terminal circuit comprises an inductance in parallel on a resistance and in parallel on a condenser.

9. A low-pass filter solely with passive components, to be used for linking up a low frequency route to a bifilar line, such bifilar line producing signals in such low frequency route and signals in a high frequency route, the said filter comprising a dispersing 2-terminal circuit interposed in a transmission branch, and at least one dual elliptic (fig.2e) and symmetrical type cell with four reels linked to the terminals of a same condenser, the four reels being reeled onto a same core, **characterized in that** the dispersing 2-terminal circuit comprises an inductance (L5pots ; L5'pots) in parallel on a resistance (R5pots ; R5'pots).

10. A filter according to claim 9, **characterized in that** the dispersing 2-terminal circuit comprises an inductance in parallel on a resistance and in parallel on a condenser.

11. A filter according to claims 9 to 10, **characterized in that** it comprises at least three elliptic 4-terminal circuit cells interposed on two transmission branches, the dispersing 2-terminal circuit being interposed on at least one branch between a first and a second cell.

12. A filter according to one of the claims 9 to 11, **characterized in that** it comprises two low frequency transmission routes linked to the bifilar line via a commutator, the two routes being filtered with cell filters of the dual elliptic and symmetrical type, with four reels linked to the terminals of a same condenser, four reels of a route's filter cell being reeled onto a same core and four other reels of another route's filter cell being reeled onto the same core.

13. A filter according to claims 9 to 12, **characterized in that** it comprises three dual elliptic and symmetric type cells mounted one beneath another with two linking inductances placed in the circuit of Figure 5, the respective components having the values indicated in the following table, at more or less 10%:
| | |
|---|---|
| L1a, Lia' | 44,1 µH |
| CT1 | 12 nF |
| L1b; L1b' | 1,6 µH |
| L2a, L2a' | 108,9 µH |
| CT2 | 13,5 nF |
| L2b, L2b' | 3,6 µH |
| L3a, L3a' | 122,5 µH |
| CT3 | 15, 39 nF |
| L3b, L3b' | 2,5 µH |
| L4, L4' | 102,4 µH |

## Patentansprüche

1. Tiefpassfilter mit lediglich passiven Bauelementen, für den Anschluss eines Niederfrequenzkanals an eine Zweidrahtleitung, wobei diese Zweidrahtleitung Signale in diesen Niederfrequenzkanal und Signale in einen Hochfrequenzkanal sendet, **dadurch gekennzeichnet, dass** es zumindest eine elliptische Zelle (Abb. 2d) oder eine zweistufig elliptische Zelle (Abb. 2e) und einen dissipativen Dipol enthält, mit einer Induktanz (L5pots ; L5'pots) parallel zu einem Widerstand (R5pots ; R5'pots), die zwischen der Übertragungs-Zweidrahtleitung und der elliptischen oder zweistufig elliptischen Zelle geschaltet, oder zwischen einem Abonnenten-Endgerät, das mit dem Filter verbunden ist, und der elliptischen oder zweistufig elliptischen Zelle geschaltet ist.

2. Filter nach Anspruch 1, **dadurch gekennzeichnet, dass** es zumindest drei elliptische Vierpolzellen enthält, die in zwei Übertragungskanälen zwischengeschaltet sind, wobei der dissipative Dipol zumindest in einem Kanal zwischen einer ersten und einer zweiten Zelle geschaltet ist.

3. Filter nach Anspruch 2, **dadurch gekennzeichnet, dass** eine Zelle zwei Übertragungskanäle enthält, wobei zumindest einer dieser Kanäle eine in Reihe geschaltete Induktanz (L1apots ; L1bpots ; L1a'pots ; L1b'pots) und einen parallel geschalteten Kondensator (CT1pots) zwischen den beiden Kanälen enthält.

4. Filter nach einem der Ansprüche 2 bis 3, **dadurch gekennzeichnet, dass** eine Zelle zwei Übertragungskanäle enthält, von denen zumindest einer eine Induktanz enthält, wobei diese Induktanz in Reihe mit einer Induktanz einer angrenzenden Zelle geschaltet ist, und ein Kondensator parallel zwischen einem Zwischenpunkt zwischen den beiden Induktanzen und dem anderen Kanal geschaltet ist.

5. Filter nach Anspruch 4, **dadurch gekennzeichnet, dass** die beiden in Reihe geschalteten Induktanzen auf einen selben Kern gewickelt sind.

6. Filter nach einem der Ansprüche 1 bis 5, **dadurch gekennzeichnet, dass** es symmetrisch ist.

7. Filter nach Anspruch 5 und Anspruch 6, **dadurch gekennzeichnet, dass** zwei in einem Übertragungskanal in Reihe geschaltete Induktanzen auf einen selben Kern gewickelt sind, wie zwei in Reihe geschaltete Induktanzen des anderen Übertragungskanals.

8. Filter nach einem der Ansprüche 1 bis 7, **dadurch gekennzeichnet, dass** der dissipative Dipol eine Induktanz enthält, die parallel zu einem Widerstand und parallel zu einem Kondensator geschaltet ist.

9. Tiefpassfilter mit lediglich passiven Bauelementen, für den Anschluss eines Niederfrequenzkanals an eine Zweidrahtleitung, wobei diese Zweidrahtleitung Signale in diesen Niederfrequenzkanal und Signale in einen Hochfrequenzkanal sendet, wobei das besagte Filter einen dissipativen Dipol enthält, der in einem Übertragungskanal zwischengeschaltet ist, und zumindest eine zweistufig elliptische und symmetrische Zelle (Abb. 2e) mit vier Spulen, die an die Klemmen eines selben Kondensators angeschlossen sind, wobei die vier Spulen auf einen selben Kern gewickelt sind, **dadurch gekennzeichnet, dass** der dissipative Dipol eine Induktanz (L5pots ; L5'pots) parallel zu einem Widerstand (R5pots ; R5'pots) enthält.

10. Filter nach Anspruch 9, **dadurch gekennzeichnet, dass** der dissipative Dipol eine Induktanz parallel zu einem Widerstand und parallel zu einem Kondensator enthält.

11. Filter nach den Ansprüchen 9 bis 10, **dadurch gekennzeichnet, dass** es zumindest drei elliptische Vierpolzellen enthält, die in zwei Übertragungskanälen zwischengeschaltet sind, wobei der dissipative Dipol in zumindest einem Kanal zwischen einer ersten und einer zweiten Zelle geschaltet ist.

12. Filter nach einem der Ansprüche 9 bis 11, **dadurch gekennzeichnet, dass** es zwei Niederfrequenz-Übertragungskanäle enthält, die durch einen Wahlschalter mit der Zweidrahtleitung verbunden sind, wobei die beiden Kanäle mit den Filtern mit zweistufig elliptischen und symmetrischen Zellen gefiltert werden, mit vier Spulen, die an die Klemmen eines selben Kondensators angeschlossen sind, wobei vier Spulen einer Zelle des Filters eines Kanals auf einen selben Kern gewickelt sind, und vier weitere Spulen einer Zelle des Filters des anderen Kanals auf denselben Kern gewickelt sind.

13. Filter nach einem der Ansprüche 9 bis 12, **dadurch gekennzeichnet, dass** es drei zweistufig elliptische und symmetrische Zellen enthält, die nacheinander mit zwei Verbindungsinduktanzen montiert, und in der Schaltung der Abbildung 5 angeordnet sind, wobei die jeweiligen Bauteile die Werte der folgenden Tabelle mit einer Genauigkeit von mehr oder weniger 10% aufweisen:
| | |
|---|---|
| L1a, Lia' | 44,1 µH |
| CT1 | 12 nF |
| L1b, L1b' | 1,6 µH |
| L2a, L2a' | 108,9 µH |
| CT2 | 13,5 nF |
| L2b, L2b' | 3,6 µH |
| L3a, L3a' | 122,5 µH |
| CT3 | 15,39 nF |
| L3b, L3b' | 2,5 µH |
| L4, L4' | 102,4 µH |
